# EUROPEAN PATENT APPLICATION

(11) **EP 4 648 108 A1**
(43) Date of publication of application: **12.11.2025**
(21) Application number: 24843306.2
(22) Date of filing: 04.06.2024
(51) Int. Cl.: H01L 25/075, H10H 20/857, H10H 20/851, H10H 20/831, H10H 20/813, H10H 20/855, H10H 29/01

(54) **DISPLAY PANEL AND MANUFACTURING METHOD THEREFOR**

(30) Priority: 18.07.2023 KR 20230093370
(71) Applicant: Samsung Electronics Co., Ltd., Suwon-si, Gyeonggi-do 16677 (KR)
(72) Inventor: YOO, Sunghyun, Suwon-si Gyeonggi-do 16677 (KR); LEE, Jinwoong, Suwon-si Gyeonggi-do 16677 (KR); LEE, Kyehoon, Suwon-si Gyeonggi-do 16677 (KR); KIM, Hyunkyung, Suwon-si Gyeonggi-do 16677 (KR); NAMKUNG, Yong, Suwon-si Gyeonggi-do 16677 (KR); LIM, Jaehee, Suwon-si Gyeonggi-do 16677 (KR); LIM, Hyoungjin, Suwon-si Gyeonggi-do 16677 (KR); JEON, Jongpil, Suwon-si Gyeonggi-do 16677 (KR)
(74) Representative: Appleyard Lees IP LLP
(86) International application number: PCT/KR2024/007655
(87) International publication number: WO 2025/018585

(57) **Abstract**

A display panel includes: a substrate; a plurality of substrate electrodes on the substrate; a plurality of first light emitting diodes electrically connected to the plurality of substrate electrodes, and configured to emit light of a first color; and a plurality of second light emitting diodes electrically connected to the plurality of substrate electrodes, each of the plurality of second light emitting diodes being configured to emit light of a second color and emit light of a third color, wherein the second color and the third color are different from the first color.

## Description

### Technical Field

The disclosure relates to a display panel and a manufacturing method thereof.

### Background Art

A display panel may include a thin-film transistor (TFT) substrate provided with a plurality of TFTs and a plurality of light emitting diodes mounted on a substrate. The plurality of light emitting diodes may be operated in a pixel or sub pixel basis and express various colors. Each of the pixels or the sub pixels may be configured such that operations thereof are controlled by the plurality of TFTs. Each light emitting diode may emit various colors such as, for example, a red color, a green color, and a blue color. The plurality of light emitting diodes may be transferred from a wafer or a relay substrate to the TFT substrate by a fix and place transfer method, a stamping transfer method, or a laser transfer method.

### Disclosure

### Technical Solution

According to an aspect of the disclosure, a display panel includes: a substrate; a plurality of substrate electrodes on the substrate; a plurality of first light emitting diodes electrically connected to the plurality of substrate electrodes, and configured to emit light of a first color; and a plurality of second light emitting diodes electrically connected to the plurality of substrate electrodes, each of the plurality of second light emitting diodes being configured to emit light of a second color and emit light of a third color, wherein the second color and the third color are different from the first color.

Each of the plurality of first light emitting diodes may include: a first vertically stacked light emitting diode including a first light emitting part and a second light emitting part which are vertically stacked; a color conversion layer on a light emitting surface of the first light emitting part; and a first contact electrode, a second contact electrode, a third contact electrode, and a fourth contact electrode which are connected to the plurality of substrate electrodes.

The color conversion layer may include a quantum dot configured to emit light of the first color by exciting lights respectively emitted from the first light emitting part and the second light emitting part.

The first light emitting part and the second light emitting part may be connected in series via the plurality of substrate electrodes.

The first light emitting part and the second light emitting part may be connected in series via the first contact electrode, the second contact electrode, the third contact electrode, and the fourth contact electrode.

The first contact electrode may be connected to a positive pole of the first light emitting part and a negative pole of the second light emitting part, the second contact electrode may be connected to a negative pole of the first light emitting part, the third contact electrode may be connected to a positive pole of the second light emitting part, and the fourth contact electrode may not be connected with the first light emitting part and the second light emitting part.

Each of the plurality of second light emitting diodes may include: a second vertically stacked light emitting diode including a third light emitting part and a fourth light emitting part which are vertically stacked; a transparent optical layer on a light emitting surface of the third light emitting part; and a fifth contact electrode, a sixth contact electrode, a seventh contact electrode, and an eighth contact electrode connected to the plurality of substrate electrodes.

The third light emitting part may be configured to emit light of the second color, and the fourth light emitting part may be configured to emit light of the third color.

The fifth contact electrode may be connected to a negative pole of the third light emitting part, the sixth contact electrode may be connected to a positive pole of the third light emitting part, the seventh contact electrode may be connected to a negative pole of the fourth light emitting part, and the eighth contact electrode may be connected to a positive pole of the fourth light emitting part.

According to an aspect of the disclosure, a light emitting diode includes: a first light emitting part configured to emit light of a blue wavelength band; a second light emitting part on the first light emitting part and configured to emit light of a green wavelength band; a color conversion layer on a light emitting surface of the first light emitting part and including a quantum dot configured to emit light of a red wavelength band by exciting lights respectively emitted from the first light emitting part and the second light emitting part; and a plurality of contact electrodes including a first contact electrode, a second contact electrode, a third contact electrode, and a fourth contact electrode.

According to an aspect of the disclosure, a light emitting diode includes: a first light emitting part configured to emit light of a blue wavelength band; a second light emitting part on the first light emitting part and configured to emit light of a green wavelength band; a transparent optical layer on a light emitting surface of the first light emitting part and configured to transmit light emitted from the first light emitting part and light emitted from the second light emitting part; a first contact electrode connected to a negative pole of the first light emitting part; a second contact electrode connected to a positive pole of the first light emitting part; a third contact electrode connected to a negative pole of the second light emitting part; and a fourth contact electrode connected to a positive pole of the second light emitting part.

According to an aspect of the disclosure, a method of manufacturing a display panel, includes: forming a plurality of first vertically stacked light emitting diodes and a plurality of second vertically stacked light emitting diodes, the plurality of second vertically stacked light emitting diodes including a first light emitting part configured to emit light of a first color at a wafer, and a second light emitting part configured to emit light of a second color at the wafer, the first color being different from the second color; transferring the plurality of first vertically stacked light emitting diodes and the plurality of second vertically stacked light emitting diodes from the wafer to a substrate; forming a plurality of first light emitting diodes by forming a color conversion layer configured to emit light of the first color and light of a third color at a light emitting surface of the plurality of first vertically stacked light emitting diodes, the third color being different from the second color; and forming a plurality of second light emitting diodes by forming a transparent optical layer at a light emitting surface of the plurality of second vertically stacked light emitting diodes. The first light emitting part and the second light emitting part may be connected in series.

### Description of Drawings

The above and other aspects, features, and advantages of certain embodiments of the present disclosure will be more apparent from the following description taken in conjunction with the accompanying drawings, in which:
FIG. 1 is a diagram illustrating a display panel according to one or more embodiments;
FIG. 2 is a diagram illustrating an example of a first light emitting diode and a second light emitting diode which form one pixel being arrayed in a horizontal direction according to one or more embodiments;
FIG. 3 is a diagram illustrating an example of a first light emitting diode and a second light emitting diode which form one pixel being arrayed in a vertical direction according to one or more embodiments;
FIG. 4 is a diagram illustrating a bottom surface of a vertically stacked light emitting diode according to one or more embodiments;
FIG. 5 is a cross-sectional view taken along line A-A' shown in FIG. 4;
FIG. 6 is a diagram illustrating a substrate according to one or more embodiments;
FIG. 7 is a diagram illustrating an example of a plurality of light emitting diodes transferred to a substrate according to one or more embodiments;
FIG. 8 is a circuit diagram schematically illustrating a connection of a first substrate electrode group with a first light emitting diode on a substrate according to one or more embodiments;
FIG. 9 is a circuit diagram schematically illustrating a connection of a second substrate electrode group with a second light emitting diode on a substrate according to one or more embodiments;
FIG. 10 is a flowchart illustrating a manufacturing method of a vertically stacked light emitting diode according to one or more embodiments;
FIG. 11, FIG. 12, FIG. 13, FIG. 14, FIG. 15, FIG. 16, FIG. 17, FIG. 18, FIG. 19, FIG. 20, FIG. 21, FIG. 22, FIG. 23, and FIG. 24 are diagrams illustrating a manufacturing method of a vertically stacked light emitting diode according to one or more embodiments;
FIG. 25 is a flowchart illustrating a manufacturing method of a display panel according to one or more embodiments;
FIG. 26 is a diagram illustrating a display panel according to one or more embodiments;
FIG. 27 is a diagram illustrating a bottom surface of a vertically stacked light emitting diode according to one or more embodiments;
FIG. 28 is a cross-sectional view taken along line B-B' shown in FIG. 27;
FIG. 29 is a diagram illustrating a substrate according to one or more embodiments;
FIG. 30 is a diagram illustrating an example of a plurality of light emitting diodes transferred to a substrate according to one or more embodiments;
FIG. 31 is a diagram illustrating an example of a plurality of vertically stacked light emitting diodes of different types grown from a single wafer according to one or more embodiments;
FIG. 32, FIG. 33, FIG. 34, FIG. 35, FIG. 36, and FIG. 37 are diagrams illustrating a manufacturing method of a vertically stacked light emitting diode according to one or more embodiments; and
FIG. 38 is a block diagram illustrating a display device according to one or more embodiments.

### Detailed Description of Exemplary Embodiments

Various embodiments will be described in greater detail below with reference to the accompanied drawings. One or more embodiments described herein may be variously modified. A specific embodiment may be illustrated in the drawings and described in detail in the detailed description. However, the specific embodiment described in the accompanied drawing is only to assist in the easy comprehension of the various embodiments. Accordingly, it should be noted that the technical spirit is not limited by the specific embodiments described in the accompanied drawings, and should be interpreted to include all modifications, combinations, equivalents and/or alternatives of the embodiments included in the spirit of the disclosure and in the technical scope.

In connection with the description of the drawings, like or similar reference numerals may be used for like or similar elements. In the disclosure, terms including ordinal numbers such as first and second may be used in describing the various elements, but the elements are not limited by the above-described terms. The above-described terms may be used only for the purpose of distinguishing one element from another element. In the disclosure, it is to be understood that the terms such as "include" or "have" are used herein to designate a presence of a characteristic, number, step, operation, element, component, or a combination thereof, and not to preclude a presence or a possibility of adding one or more of other characteristics, numbers, steps, operations, elements, components or a combination thereof. When a certain element is indicated as being "coupled with/to" or "connected to" another element, it may be understood as the certain element being directly coupled with/to or connected to the another element, or other element being present therebetween. Conversely, when a certain element is indicated as "directly coupled with/to" or "directly connected to" another element, it may be understood as other element not being present therebetween. In the disclosure, the expression "same" may refer to not only fully matching, but also include a difference of an extent that considers a processing error range. In case it is determined that the detailed description of related known technologies or configurations may unnecessarily confuse the gist of the disclosure, the detailed description thereof will be omitted.

An embodiments of the disclosure will be described in detail below with reference to the accompanying drawings to aid in the understanding of those of ordinary skill in the art. However, an embodiment of the disclosure may be implemented to various different forms, and is not limited to an embodiment of the disclosure described herein.

A display panel and a vertically stacked light emitting diode included in the display panel according to one or more embodiments will be described below with reference to the drawings. The vertically stacked light emitting diode may be referred to as a "vertically stacked light emitting structure."

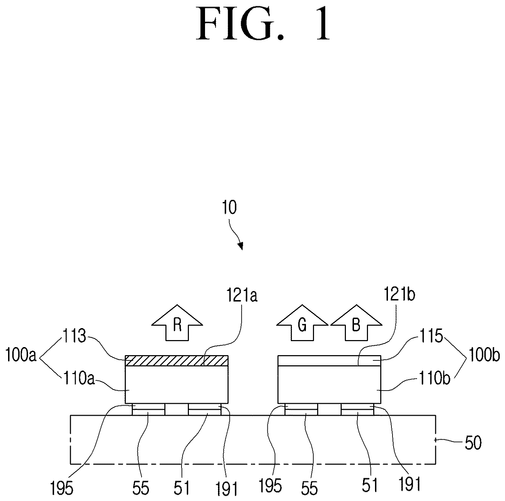

FIG. 1 is a diagram illustrating a display panel according to one or more embodiments.

Referring to FIG. 1, a display panel 10 may include a substrate 50, and a plurality of first light emitting diodes 100a and a plurality of second light emitting diodes 100b arrayed on the substrate 50.

A TFT layer may be formed at a front surface of the substrate, and a power supply circuit which supplies power to the TFT layer, a data driving circuit, a gate driving driver, and a timing controller which controls the respective driving drivers may be disposed at a back surface thereof.

The TFT layer may include a plurality of TFTs for driving the plurality of first light emitting diodes 100a and the plurality of second light emitting diodes 100b. The TFT layer may be integrally formed at the front surface of the substrate 50, but it not limited thereto, and may be manufactured as a separate film form and attached to the front surface of the substrate 50. A plurality of substrate electrodes (first substrate electrode 51, second substrate electrode 53, third substrate electrode 55, and fourth substrate electrode 57) (referring to FIG. 1, FIG. 2, FIG. 3, and FIG. 4) disposed on the TFT layer may be electrically connected with the TFT layer.

The plurality of TFT included in the TFT layer is not limited to the specific structure or type. For example, a TFT may be implemented as a low-temperature polycrystalline silicon TFT (LTPS TFT), an oxide TFT, a poly silicon or a-silicon (Si) TFT, an organic TFT, a graphene TFT, and the like. The TFT layer may apply a Si wafer to the substrate 50 by forming only a P-type (or N-type) metal oxide semiconductor field effect transistor (MOSFET) in a complementary metal oxide semiconductor (CMOS) process.

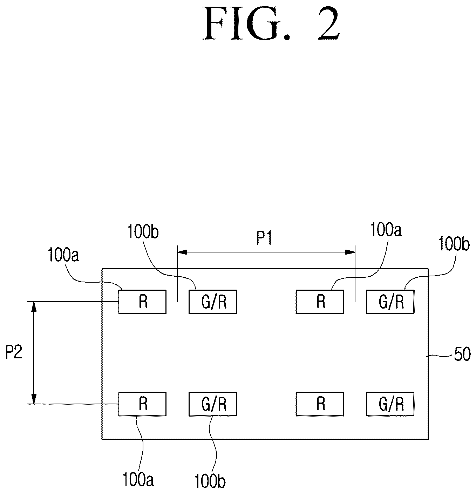

A conductive adhesive layer may be stacked on the TFT layer. The conductive adhesive layer may include a flux in which a plurality of fine metal grains are included. For example, the conductive adhesive layer may be a non-conductive resin and an anisotropic conductive film on which fine conductive particles are regularly or non-regularly arrayed in the non-conductive resin. In this case, the non-conductive resin may have a blackish color so as to absorb external light. The external light may be natural light or light emitted from lightings disposed at a surrounding of the display panel. A plurality of device electrodes (first contact electrode 191, second contact electrode 193, third contact electrode 195, and fourth contact electrode 197) (referring to FIG. 1 and FIG. 2) provided at the respective vertically stacked light emitting diodes 100a and 100b and the plurality of substrate electrodes (first substrate electrode 51, second substrate electrode 53, third substrate electrode 55, and fourth substrate electrode 57) of the substrate 50 may be electrically and physically interconnected by the conductive adhesive layer.

A first light emitting diode 100a may include a first vertically stacked light emitting diode 110a and a color conversion layer 113 stacked at a light emitting surface of the first vertically stacked light emitting diode 110a.

The first vertically stacked light emitting diode 110a may include a first light emitting part 120 that emits light of a first color and a second light emitting part 160 which is stacked at the first light emitting part 120 and emits light of a second color different from the first color. For example, light of the first color may be a blue light, and light of the second color may be a green light. The first vertically stacked light emitting diode 110a may be driven to individually emit light of the first color and light of the second color, respectively.

The color conversion layer 113 may include a red quantum dot (QD) which can emit light of a red wavelength band by being excited by light emitted from the first vertically stacked light emitting diode 110a. A quantum dot may mean a semiconductor particle in a small spherical form of a nanometer size (nm, one one-billionth meter), and may be configured with a central body of a size of about 2 nanometers (nm) to 10 nm and a shell formed of zinc sulfide (ZnS). Here, cadmium selenide (CdSe), cadmium telluride (CdTe), cadmium sulfide (CdS), or the like may be used as the central body of the quantum dot. The quantum dot may emit light of a wavelength specified by itself when an electric field is applied, or emit light of a specific wavelength when high energy light is absorbed. At this time, the wavelength of light being emitted may rely on a size of the quantum dot. Light of a short wavelength may be emitted the smaller the size of the quantum dot is, and light of a long wavelength may be emitted the larger the size of the quantum dot is. For example, a quantum dot with a diameter of about 6 nm may emit roughly a red light.

In addition, the color conversion layer 113 may include a red nanophosphor which can emit light of a red wavelength band by being exited by light emitted from the first vertically stacked light emitting diode 110a. For example, the red nanophosphor may be SCASN(Si₁₋ₓCaₓAlSiN₃:Eu²⁺). In this case, the red nanophosphor may have a particle size distribution average value d₅₀ of less than 0.5 µm (for example, 0.1 µm< d₅₀ < 0.5 µm).

A second light emitting diode 100b may include a transparent optical layer 115 stacked at a light emitting surface 111b of a second vertically stacked light emitting diode 110b. The second vertically stacked light emitting diode 110b may be substantially the same as with the first vertically stacked light emitting diode 110a. The transparent optical layer 115 may be formed of a material that does not affect a transmittance, reflectivity, and refractive index of light emitted from the second vertically stacked light emitting diode 110b.

The first light emitting diode 100a may include the first vertically stacked light emitting diode 110a and the second vertically stacked light emitting diode 110b. The second vertically stacked light emitting diode 110b may include the first vertically stacked light emitting diode 110a and the second vertically stacked light emitting diode 110b substantially the same as the first light emitting diode 100a. In this case, the first light emitting diode 100a may emit a red light through the color conversion layer 113, and the second light emitting diode 100b may emit a green light and blue light individually.

The color conversion layer 113 and the transparent optical layer 115 may be respectively formed on the first vertically stacked light emitting diode 110a and the second vertically stacked light emitting diode 110b after the first vertically stacked light emitting diode 110a and the second vertically stacked light emitting diode 110b are transferred to the substrate 50. As described above, the first light emitting diode 100a may include the first vertically stacked light emitting diode 110a and the color conversion layer 113. The second light emitting diode 100b may include the second vertically stacked light emitting diode 110b and the transparent optical layer 115.

According to one or more embodiments, compared to using three light emitting diodes (a red light emitting diode, a green light emitting diode, a blue light emitting diode) to form one pixel, the one pixel may be formed with the first light emitting diode 100a including the first vertically stacked light emitting diode 110a and the second vertically stacked light emitting diode 110b of one type (here, "one type" means having a same structure) and the second light emitting diode 100b including the first vertically stacked light emitting diode 110a and the second vertically stacked light emitting diode 110b of one type.

Accordingly, when applying the first light emitting diode 100a and the second light emitting diode 100b to the display panel 10, there may not necessarily be provided a red light emitting diode emitting a red light, a blue light emitting diode emitting a blue light, and a green light emitting diode emitting a green light respectively. According to one or more embodiments, by reducing the number of light emitting diodes that form one pixel from three to two, the area occupied by the one pixel may be improved (reduced) to about 2/3 level compared to when using three R/G/B light emitting diodes. Accordingly, a pixel structure provided in the display panel 10 may be simplified and a manufacturing process of the display panel 10 may be simplified.

Referring to FIG. 2, the first light emitting diode 100a and the second light emitting diode 100b which form one pixel may be arrayed in a first direction. Here, the first direction may be a horizontal direction in FIG. 2. Pixels adjacent to one another may have a first pitch P1 in the horizontal direction and have a second pitch P2 in a vertical direction.

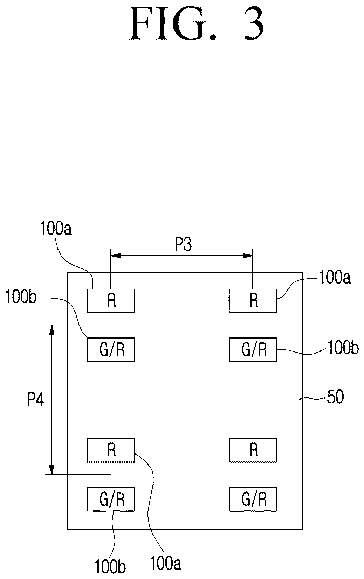

Referring to FIG. 3, the first light emitting diode 100a and the second light emitting diode 100b which form one pixel may be arrayed in a second direction. Here, the second direction may be a vertical direction in FIG. 3. Pixels adjacent to one another may have a third pitch P3 in the horizontal direction, and have a fourth pitch P4 in the vertical direction.

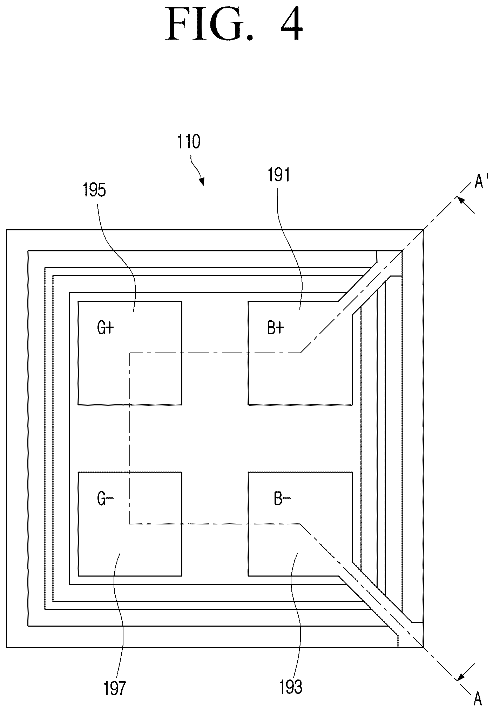

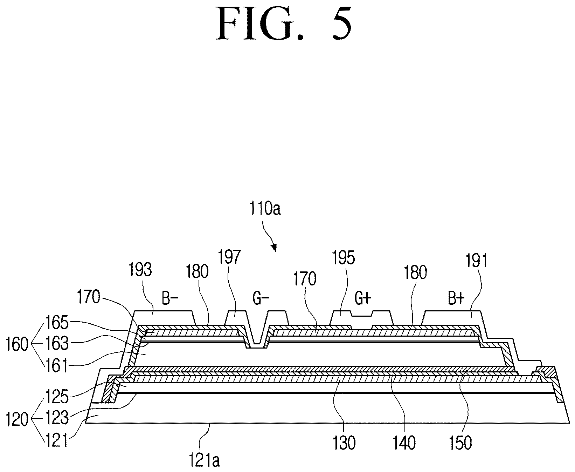

FIG. 4 is a diagram illustrating a bottom surface of a vertically stacked light emitting diode according to one or more embodiments. FIG. 5 is a cross-sectional view taken along line A-A' shown in FIG. 4. Due to the first vertically stacked light emitting diode 110a and the second vertically stacked light emitting diode 110b having substantially the same structure, only the first vertically stacked light emitting diode 110a will be described below.

Referring to FIG. 4 and FIG. 5, the first vertically stacked light emitting diode 110a may be formed in a flip chip form provided with a plurality of contact electrodes device electrodes (first contact electrode 191, second contact electrode 193, third contact electrode 195, and fourth contact electrode 197) at an opposite surface of a light emitting surface 121a.

The first vertically stacked light emitting diode 110a may include the first light emitting part 120, a first transparent electrode layer 130, the second light emitting part 160, a second transparent electrode layer 170, and four contact electrodes. The four contact electrodes may include a first contact electrode 191, a second contact electrode 193, a third contact electrode 195, and a fourth contact electrode 197.

The first light emitting part 120 may include a first semiconductor layer 121, a second semiconductor layer 125, and a first active layer 123 provided between the first semiconductor layer 121 and the second semiconductor layer 125.

The first semiconductor layer 121, the second semiconductor layer 125, and the first active layer 123 may be formed using methods such as a metal organic chemical vapor deposition (MOCVD) method, a chemical vapor deposition (CVD) method, a plasma-enhanced chemical vapor deposition (PECVD) method, and the like.

The first semiconductor layer 121 may include, for example, a p-type semiconductor layer. The p-type semiconductor layer may be selected from, for example, GaN, AlN, AlGaN, InGaN, InN, InAlGaN, AlInN, and the like, and a p-type dopant of Mg, Zn, Ca, Sr, Ba, and the like may be doped.

The second semiconductor layer 125 may include, for example, an n-type semiconductor layer. The n-type semiconductor layer may be selected from, for example, GaN, AlN, AlGaN, InGaN, InN, InAlGaN, AlInN, and the like, and an n-type dopant of Si, Ge, Sn, and the like may be doped.

The first light emitting part 120 may not be limited to the above-described configuration, and for example, the first semiconductor layer 121 may include the n-type semiconductor layer, and the second semiconductor layer 125 may include the p-type semiconductor layer.

The first active layer 123 may be an area in which electrons and holes are recombined, which transitions to a low energy level as electrons and holes recombine, and may generate light having an wavelength corresponding thereto. The first active layer 123 may include a semiconductor material, for example, an amorphous silicon or a poly crystalline silicon. However, the embodiments are not limited thereto, and other embodiments contain an organic semiconductor material, and the like, and may be formed in a single quantum well (SQW) structure or a multi quantum well (MQW) structure. The first active layer 123 may emit light of a blue wavelength band 455 to 475 nm.

The first transparent electrode layer 130 (e.g., indium tin oxide (ITO)) may be provided on the second semiconductor layer 125. The first transparent electrode layer 130 may be electrically connected with the second semiconductor layer 125. The first transparent electrode layer 130 may be covered by a first passivation layer 140.

The first passivation layer 140 may be an insulating material (e.g., SiO2, Al2O3, SiN, etc.), and may be depositioned at the first transparent electrode layer 130 by techniques such as an atomic layer deposition, an e-beam deposition, sputtering, a chemical vapor deposition, and spin coating. The first passivation layer 140 may isolate the first light emitting part 120 and the second light emitting part 160 physically from each other and may be physically and electrically isolated. On the first passivation layer 140, a mirror layer such as distributed Bragg reflectors (DBR) may be stacked to enhance light extraction efficiency of the first light emitting part 120.

The second light emitting part 160 may be attached in a stacked state to the first light emitting part 120 by a bonding layer 150. The bonding layer 150 may be provided between the first passivation layer 140 and a third semiconductor layer 161 of the second light emitting part 160.

The second light emitting part 160 may include the third semiconductor layer 161, a fourth semiconductor layer 165, and a second active layer 163 provided between the third semiconductor layer 161 and the fourth semiconductor layer 165.

The third semiconductor layer 161, the fourth semiconductor layer 165, and the second active layer 163 may be formed using methods such as, the metal organic chemical vapor deposition (MOCVD) method, the chemical vapor deposition (CVD) method, the plasma-enhanced chemical vapor deposition (PECVD) method, and the like.

The third semiconductor layer 161 may include, for example, the p-type semiconductor layer. The p-type semiconductor layer may be selected from, for example, GaN, AlN, AlGaN, InGaN, InN, InAlGaN, AlInN, and the like, and the p-type dopant of Mg, Zn, Ca, Sr, Ba, and the like may be doped.

The fourth semiconductor layer 165 may include, for example, the n-type semiconductor layer. The n-type semiconductor layer may be selected from, for example, GaN, AlN, AlGaN, InGaN, InN, InAlGaN, AlInN, and the like, and the n-type dopant of Si, Ge, Sn, and the like may be doped.

The second light emitting part 160 may not be limited to the above-described configuration, and for example, the third semiconductor layer 161 may include the n-type semiconductor layer, and the fourth semiconductor layer 165 may include the p-type semiconductor layer.

The second active layer 163 may include the semiconductor material, for example, the amorphous silicon or the poly crystalline silicon. In addition, the second active layer 163 may contain the organic semiconductor material, and the like, and may be formed in the single quantum well (SQW) structure or the multi quantum well (MQW) structure. The second active layer 163 may emit light of a green wavelength band 520 to 535 nm.

The second transparent electrode layer 170 may be provided on the fourth semiconductor layer 165. The second transparent electrode layer 170 may be electrically connected with the fourth semiconductor layer 165. The second transparent electrode layer 170 may be covered by a second passivation layer 180.

The first contact electrode 191, the second contact electrode 193, the third contact electrode 195, and the fourth contact electrode 197 may be provided at an opposite surface of the light emitting surface 121a of the first vertically stacked light emitting diode 110a. The first contact electrode 191, the second contact electrode 193, the third contact electrode 195, and the fourth contact electrode 197 may be arrayed in a grid as in FIG. 4.

The first contact electrode 191 may be a positive pole (B+) which is electrically connected to the second semiconductor layer 125 of the first light emitting part 120 through the first transparent electrode layer 130. The second contact electrode 193 may be a negative pole (B-) which is electrically connected to the first semiconductor layer 121 of the first light emitting part 120.

The third contact electrode 195 may be a positive pole (G+) which is electrically connected to the fourth semiconductor layer 165 of the second light emitting part 160 through the second transparent electrode layer 170. The fourth contact electrode 197 may be a negative pole (G-) which is electrically connected to the third semiconductor layer 161 of the second light emitting part 160.

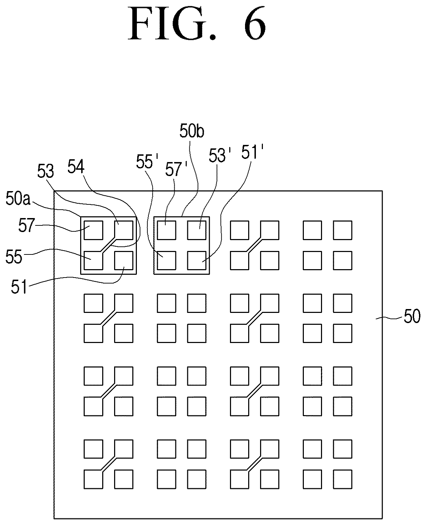

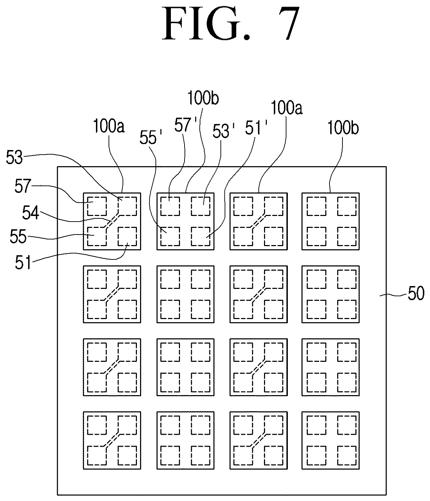

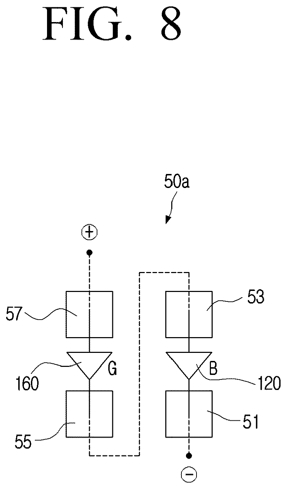

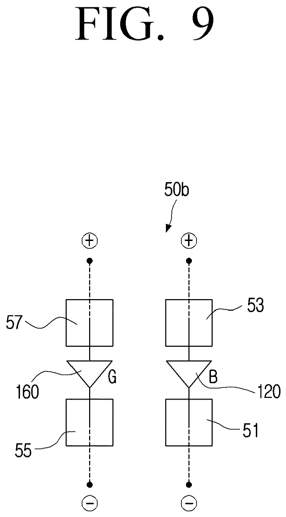

FIG. 6 is a diagram illustrating a substrate according to one or more embodiments. FIG. 7 is a diagram illustrating an example of a plurality of light emitting diodes transferred to a substrate according to one or more embodiments. FIG. 8 is a circuit diagram illustrating a connection of a first substrate electrode group with a first light emitting diode on a substrate according to one or more embodiments. FIG. 9 is a circuit diagram illustrating a connection of a second substrate electrode group with a second light emitting diode on a substrate according to one or more embodiments.

Referring to FIG. 6 and FIG. 7, the substrate 50 according to one or more embodiments may be arrayed with a plurality of substrate electrodes at the front surface thereof. The plurality of substrate electrodes may include a first substrate electrode group 50a corresponding to the first light emitting diode 100a that emit a red light and a second substrate electrode group 50b corresponding to the second light emitting diode 100b that emit a green light and a blue light.

The first substrate electrode group 50a may include first to fourth substrate electrodes (first substrate electrode 51, second substrate electrode 53, third substrate electrode 55, and fourth substrate electrode 57) which are disposed in a grid array to corresponding respectively with the first to fourth contact electrodes device electrodes (first contact electrode 191, second contact electrode 193, third contact electrode 195, and fourth contact electrode 197) of the first light emitting diode 100a. For example, first substrate electrode 51 may be electrically connected with the first contact electrode 191 of the first light emitting diode 100a, a second substrate electrode 53 may be electrically connected with the second contact electrode 193 of the first light emitting diode 100a, a third substrate electrode 55 may be electrically connected with the third contact electrode 195 of the first light emitting diode 100a, and a fourth substrate electrode 57 may be electrically connected with the fourth contact electrode 197 of the first light emitting diode 100a.

Referring to FIG. 8, the first substrate electrode group 50a may be configured such that the second substrate electrode 53 and the third substrate electrode 55 may be electrically connected by a wiring pattern 54. Accordingly, the first to fourth substrate electrodes (first substrate electrode 51, second substrate electrode 53, third substrate electrode 55, and fourth substrate electrode 57) of the first substrate electrode group 50a may be connected in series. Accordingly, the first light emitting diode 100a which is electrically connected to the first substrate electrode group 50a may be configured such that the first light emitting part 120 and the second light emitting part 160 are simultaneously driven when current is applied to the first substrate electrode group 50a. As light simultaneously emitted from the first light emitting part 120 and the second light emitting part 160 are excited by the color conversion layer 113, the first light emitting diode 100a may emit a red light.

The second substrate electrode group 50b may include fifth to eighth substrate electrodes (fifth substrate electrode 51', sixth substrate electrode 53', seventh substrate electrode 55', and eighth substrate electrode 57') disposed in a grid array to correspond respectively with the first to fourth contact electrodes device electrodes (first contact electrode 191, second contact electrode 193, third contact electrode 195, and fourth contact electrode 197) of the second light emitting diode 100b. For example, a fifth substrate electrode 51' may be electrically connected with the first contact electrode 191 of the second light emitting diode 100b, a sixth substrate electrode 53' may be electrically connected with the second contact electrode 193 of the second light emitting diode 100b, a seventh substrate electrode 55' may be electrically connected with the third contact electrode 195 of the second light emitting diode 100b, and an eighth substrate electrode 57' may be electrically connected with the fourth contact electrode 197 of the second light emitting diode 100b.

Referring to FIG. 9, the second substrate electrode group 50b is configured such that the sixth substrate electrode 53' and the seventh substrate electrode 55' are not electrically connected unlike the first substrate electrode group 50a. Accordingly, the fifth substrate electrode 51' of the second substrate electrode group 50b and the first light emitting part 120 connected to the sixth substrate electrode 53' may be individually driven from the second light emitting part 160 connected to the seventh substrate electrode 55' and the eighth substrate electrode 57'. Accordingly, when current is applied to the second substrate electrode group 50b, the second light emitting diode 100b electrically connected to the second substrate electrode group 50b may be configured such that the first light emitting part 120 and the second light emitting part 160 are individually driven. Accordingly, the second light emitting diode 100b may individually emit a blue light emitted from the first light emitting part 120 and a green light emitted from the second light emitting part 160.

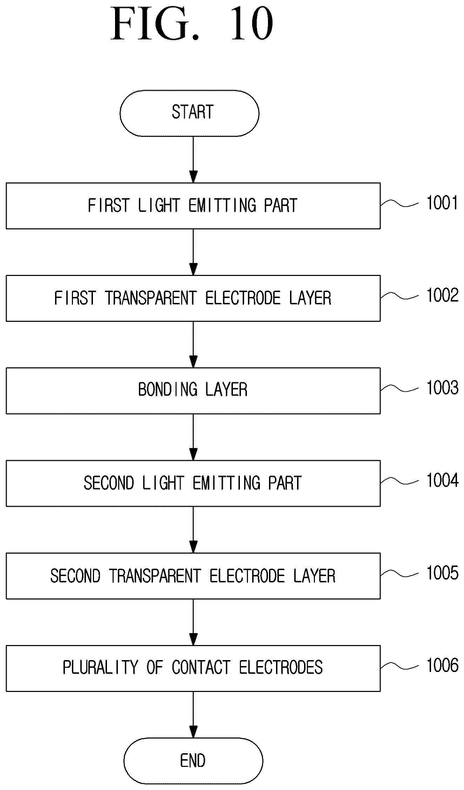

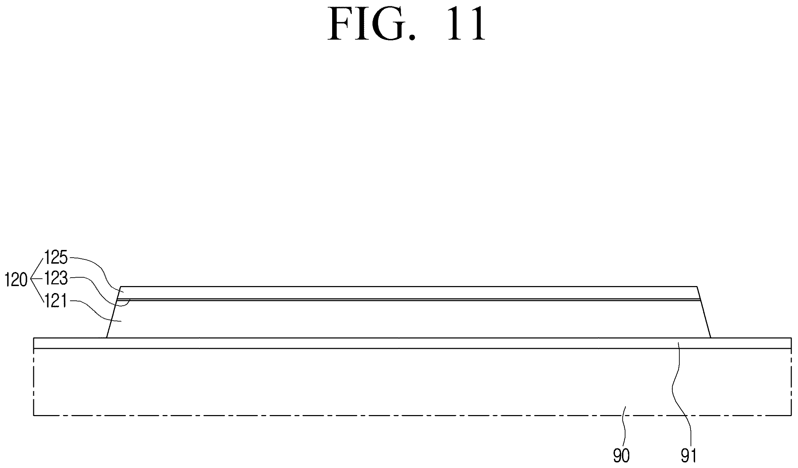

FIG. 10 is a flowchart illustrating a manufacturing method of a vertically stacked light emitting diode according to one or more embodiments. FIG. 11, FIG. 12, FIG. 13, FIG. 14, FIG. 15, FIG. 16, FIG. 17, FIG. 18, FIG. 19, FIG. 20, FIG. 21, FIG. 22, FIG. 23, and FIG. 24 are diagrams illustrating a manufacturing method of a vertically stacked light emitting diode according to one or more embodiments.

The first vertically stacked light emitting diode 110a and the second vertically stacked light emitting diode 110b may be formed on a single wafer. The first vertically stacked light emitting diode 110a and the second vertically stacked light emitting diode 110b may have a substantially same structure. A manufacturing method of a first vertically stacked light emitting diode 110a will be described below.

Referring to FIG. 11, the first light emitting part 120 is formed on a wafer 90 (e.g., a sapphire substrate) (element 1001 in FIG. 10). The first light emitting part 120 may include the first semiconductor layer 121 formed on a buffer layer 91 of the wafer 90, the second semiconductor layer 125, and the first active layer 123 formed between the first semiconductor layer 121 and the second semiconductor layer 125 through an ion injection. The first semiconductor layer 121 may be the p-type semiconductor layer doped with the p-type dopant. The second semiconductor layer 125 may be the n-type semiconductor layer doped with the n-type dopant. The first active layer 123 may include the single quantum well (SQW) structure or the multi quantum well (MQW) structure, and emit light of a blue wavelength band.

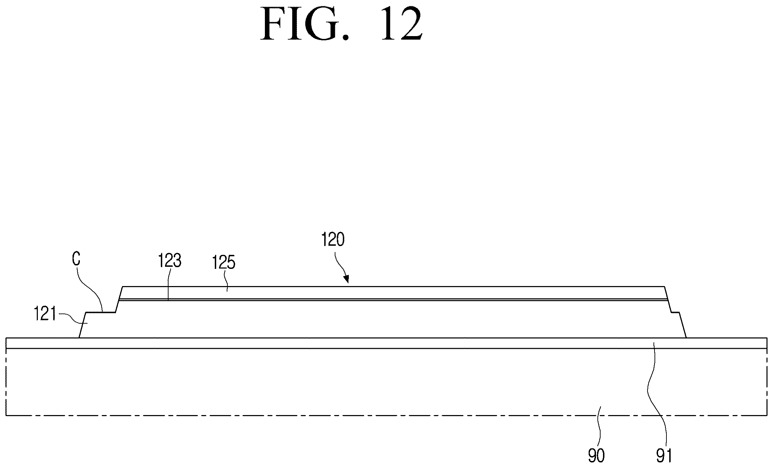

Referring to FIG. 12, a first contact part C may be formed for one end of the second contact electrode 193 to contact with the first semiconductor layer 121 by etching one side of the first light emitting part 120.

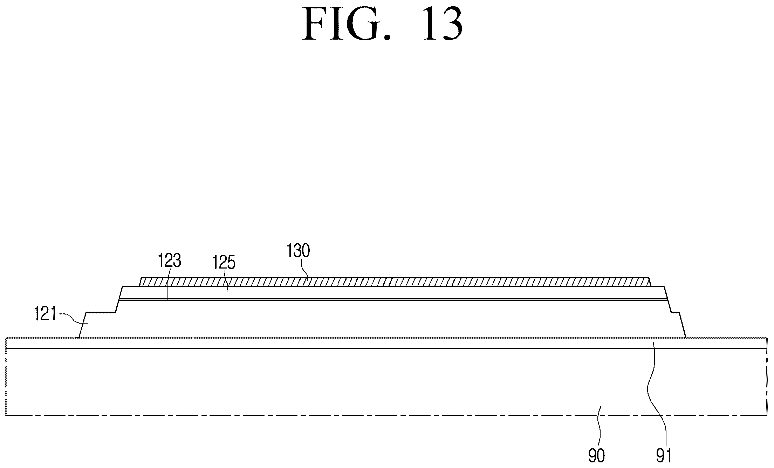

Referring to FIG. 13, the first transparent electrode layer 130 may be formed on the second semiconductor layer 125 of the first light emitting part 120 (element 1002 in FIG. 10). The first transparent electrode layer 130 may be contacted with one end of the first contact electrode 191.

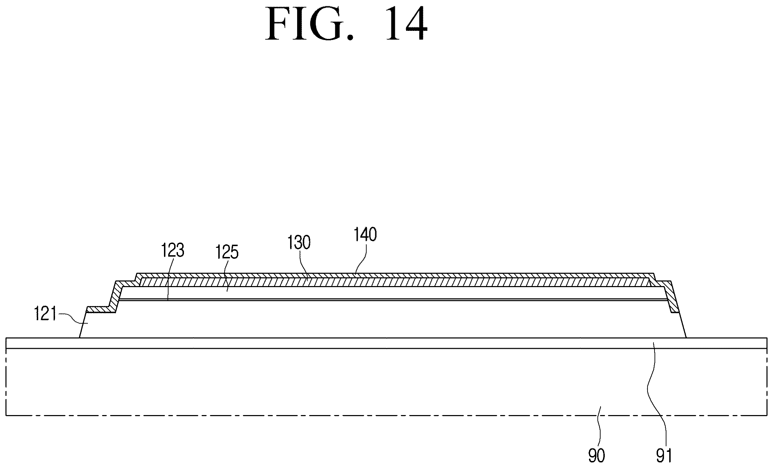

Referring to FIG. 14, the first transparent electrode layer 130 may block an electrical connection with the second light emitting part 160 and form the first passivation layer 140 to protect the first light emitting part 120. The first passivation layer 140 may cover the first transparent electrode layer 130, and cover a portion of the first light emitting part 120 which is not covered by the first light emitting part 120. In this case, the first contact part C of the first semiconductor layer 121 may be covered by the first passivation layer 140.

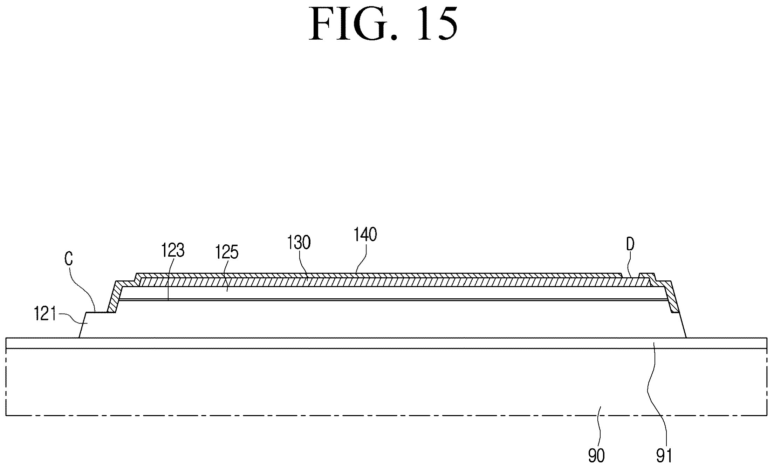

Referring to FIG. 15, a second contact part which can contact with one end of the first contact electrode 191 may be exposed by etching one portion of the first passivation layer 140, and the first contact part C which can contact with one end of the second contact electrode 193 may be exposed by etching another portion of the first passivation layer 140. A second contact part D may be a portion of the first transparent electrode layer 130.

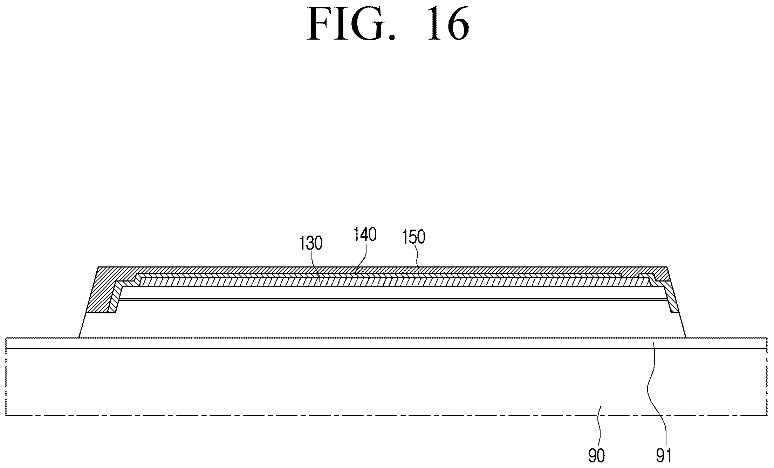

Referring to FIG. 16, the bonding layer 150 may be formed at the first light emitting part 120 to connect the second light emitting part 160 which is to be stacked at an upper side of the first light emitting part 120 with the first light emitting part 120 (element 1003 in FIG. 10). In this case, the first passivation layer 140 may be covered by the bonding layer 150 together with the first light emitting part 120.

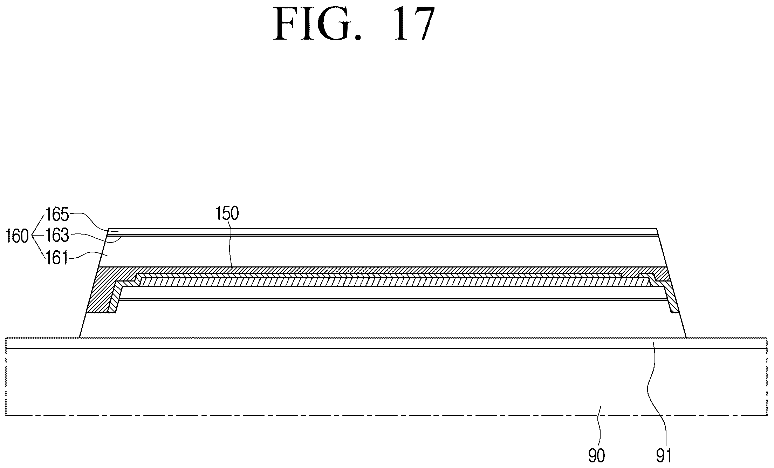

Referring to FIG. 17, the second light emitting part 160 may be formed on the bonding layer 150 (element 1004 in FIG. 10). The second light emitting part 160 may form the third semiconductor layer 161, the fourth semiconductor layer 165, and the second active layer 163 between the third semiconductor layer 161 and the fourth semiconductor layer 165 through an ion injection. The third semiconductor layer 161 may be the p-type semiconductor layer doped with the p-type dopant. The fourth semiconductor layer 165 may be the n-type semiconductor layer doped with the n-type dopant. The second active layer 163 may include the single quantum well (SQW) structure or the multi quantum well (MQW) structure, and emit light of a green wavelength band.

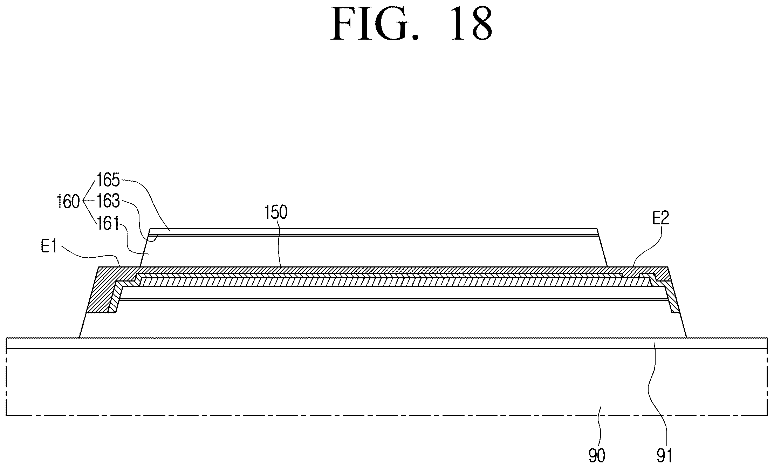

Referring to FIG. 18, a first edge part E1 and a second edge part E2 of the bonding layer 150 are exposed by etching a portion of a second light emitting layer. The first edge part E1 may be at a position corresponding to the first contact part C of the first semiconductor layer 121, and the second edge part E2 may be at a position corresponding to the second contact part D of the first transparent electrode layer 130.

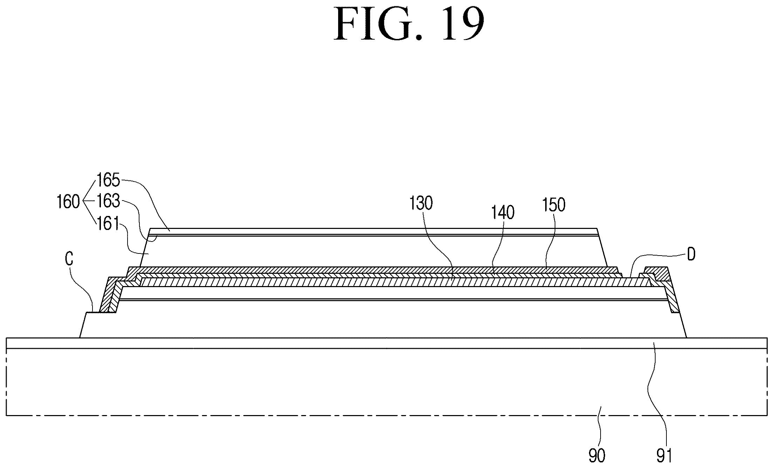

Referring to FIG. 19, the first contact part C of the first semiconductor layer 121 and the second contact part D of the first transparent electrode layer 130 may be respectively exposed by etching a portion of the bonding layer 150.

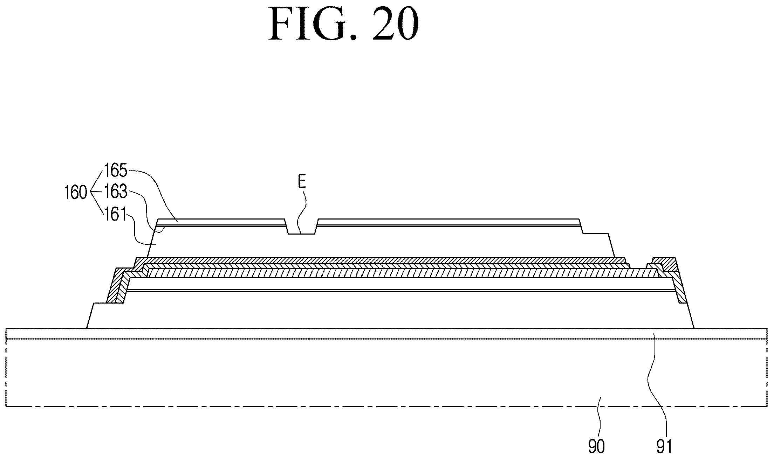

Referring to FIG. 20, a third contact part E may be exposed for the fourth contact electrode 197 to contact the third semiconductor layer 161 of the second light emitting part 160 by etching a portion of the second light emitting part 160.

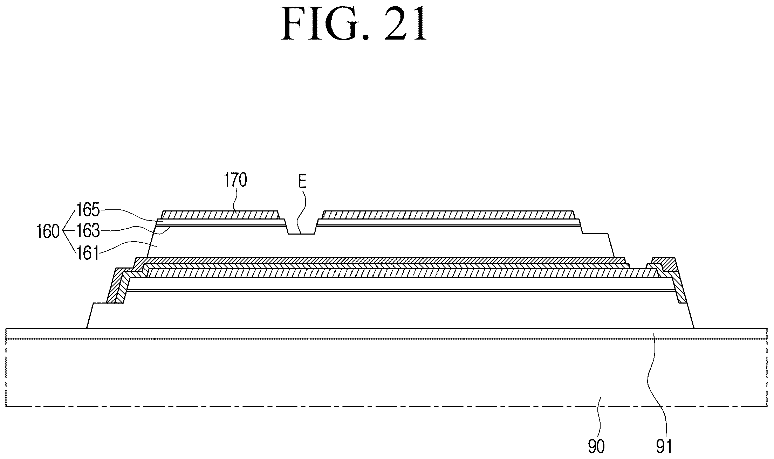

Referring to FIG. 21, the second transparent electrode layer 170 may be formed on the fourth semiconductor layer 165 of the second light emitting part 160 (element 1005 in FIG. 10). The second transparent electrode layer 170 may be contacted with one end of the third contact electrode 195. The second transparent electrode layer 170 may be configured such that a portion thereof is etched for the third contact part E of the third semiconductor layer 161 to be exposed.

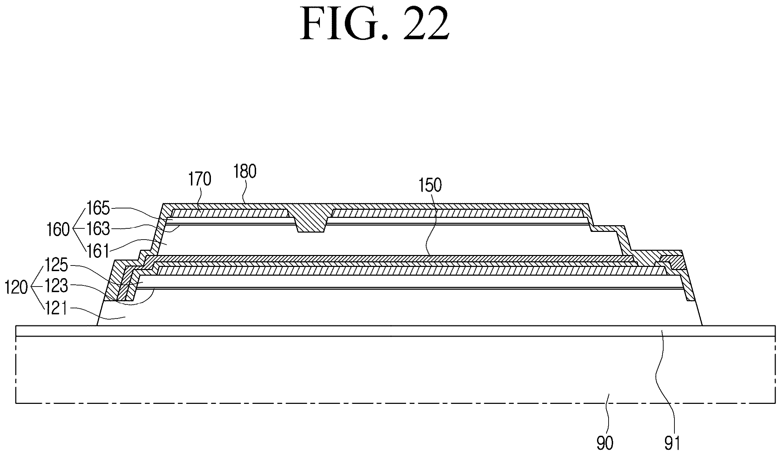

Referring to FIG. 22, the second passivation layer 180 may be formed to cover the second light emitting part 160. The second passivation layer 180 may cover both an exposed portion of the first light emitting part 120 and an exposed portion of the bonding layer 150.

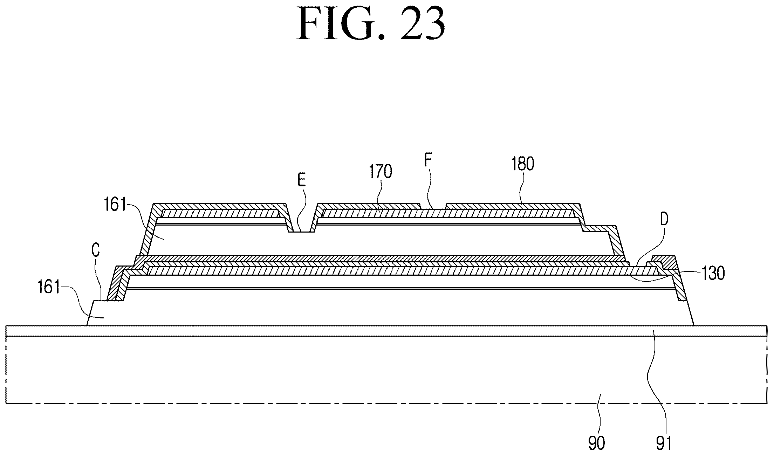

Referring to FIG. 23, the first contact part C of the first semiconductor layer 121, the second contact part D of the first transparent electrode layer 130, the third contact part E of the third semiconductor layer 161, and a fourth contact part F of the second transparent electrode layer 170 may be exposed by etching each portions of the second passivation layer 180.

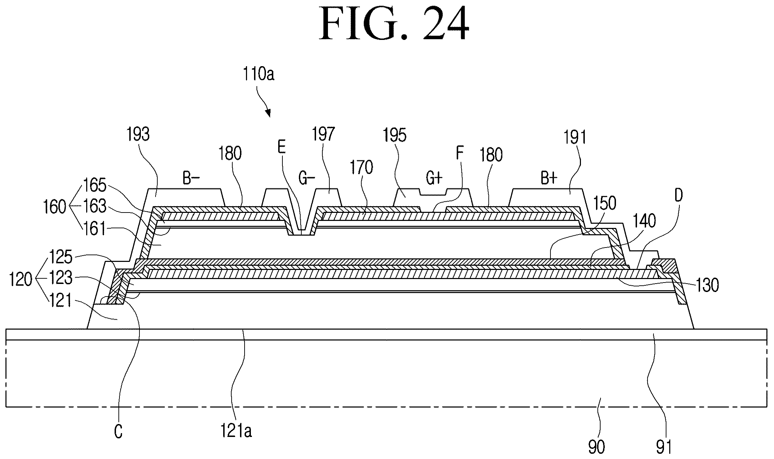

Referring to FIG. 24, the first contact electrode 191, the second contact electrode 193, the third contact electrode 195, and the fourth contact electrode 197 may be formed on the second passivation layer 180 (element 1106 of FIG.11). The first contact electrode 191, the second contact electrode 193, the third contact electrode 195, and the fourth contact electrode 197 may be arrayed roughly in a grid form.

The first contact electrode 191 may be contacted at the second contact part D of the first transparent electrode layer 130. The second contact electrode 193 may be contacted at the first contact part C of the first semiconductor layer 121. The third contact electrode 195 may be contacted at the fourth contact part F of the second transparent electrode layer 170. The fourth contact electrode 197 may be contacted at the third contact part E of the third semiconductor layer 161.

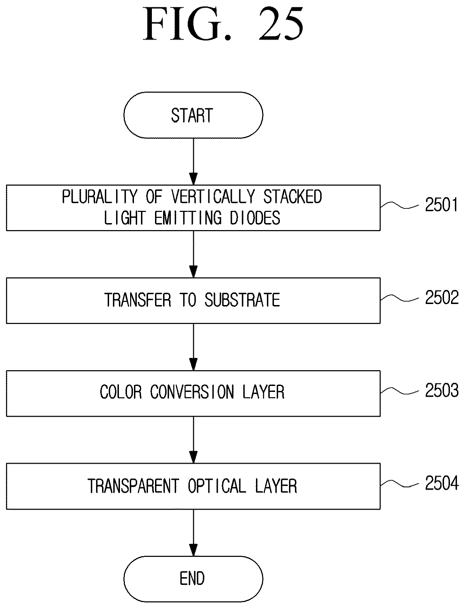

FIG. 25 is a flowchart illustrating a manufacturing method of a display panel according to one or more embodiments.

A manufacturing method of the display panel 10 according to one or more embodiments may include individually separating and forming the plurality of first vertically stacked light emitting diodes 110a and the plurality of second vertically stacked light emitting diodes 110b through an isolation process after having grown the vertically stacked light emitting diode structure on a wafer (element 2501 in FIG. 25). Here, the first vertically stacked light emitting diode 110a and the second vertically stacked light emitting diode 110b may have a substantially same structure.

The plurality of first vertically stacked light emitting diodes 110a and the plurality of second vertically stacked light emitting diodes 110b formed at the wafer may be directly transferred to the substrate 50 (referring to FIG. 1; here, the substrate 50 may be referred to as a "target substrate") or transferred to a separate transfer substrate through a transfer process (element 2502 in FIG. 25). When transferred to the separate transfer substrate, the plurality of first vertically stacked light emitting diodes 110a and the plurality of second vertically stacked light emitting diodes 110b may be transferred from the wafer to a first transfer substrate, and after being transferred from the first transfer substrate to a second transfer substrate, may be ultimately transferred from the second transfer substrate to the substrate 50. For example, the transfer process may involve applying a laser transfer method, a stamp transfer method, a rollable transfer method, or a pick and place transfer method.

The color conversion layer 113 (referring to FIG. 1) may be formed at the light emitting surface 121a of the plurality of first vertically stacked light emitting diodes 110a transferred to the substrate (element 2503 in FIG. 25).

The transparent optical layer 115 (referring to FIG. 1) may be formed at a light emitting surface 121b (referring to FIG. 1) of the plurality of second vertically stacked light emitting diodes 110b transferred to the substrate 50 (element 2504 in FIG. 25). In the disclosure, a process of forming the color conversion layer 113 has been described as preceding a process of forming the transparent optical layer 115, but is not limited thereto. For example, the process of forming the color conversion layer 113 may be performed after the process of forming the transparent optical layer 115.

According to one or more embodiments, the first vertically stacked light emitting diode 110a and the second vertically stacked light emitting diode 110b of one type may be transferred from one wafer to the substrate 50. Unlike the above, when light emitting diodes of three individual types are transferred, three wafers corresponding to the red, green, and blue light emitting diodes are required, and the light emitting diodes of each wafer is the be sequentially transferred to the substrate. Accordingly, in the disclosure, time spent in the transfer process may be improved (reduced) to roughly 1/3 level compared to the process of transferring the light emitting diodes of the three individual types described above.

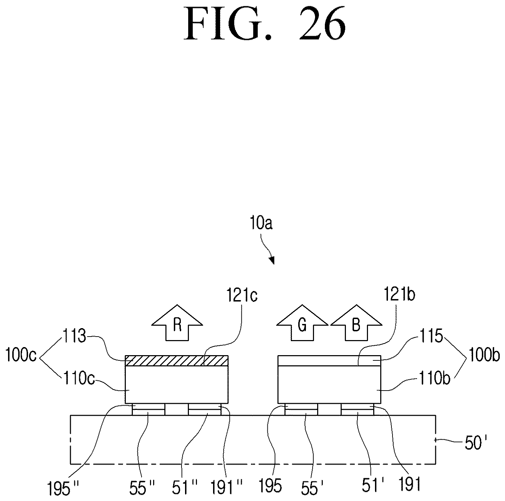

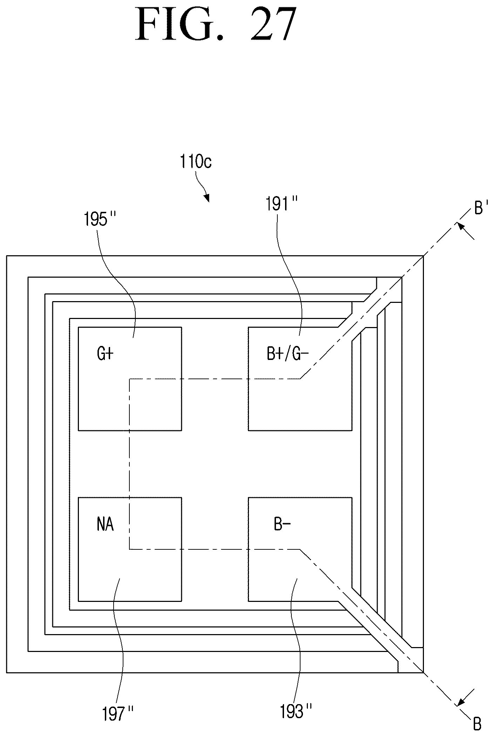

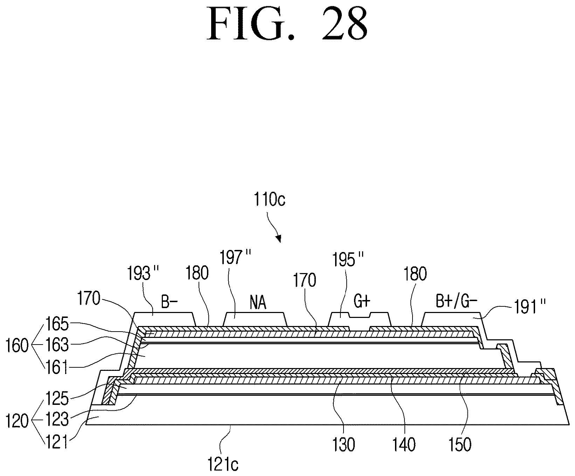

FIG. 26 is a diagram illustrating a display panel according to one or more embodiments. FIG. 27 is a diagram illustrating a bottom surface of a vertically stacked light emitting diode according to one or more embodiments. FIG. 28 is a cross-sectional view taken along line B-B' shown in FIG. 27.

Referring to FIG. 26, according to one or more embodiments, a plurality of pixels provided in a display panel 10a may respectively include the second light emitting diode 100b and a third light emitting diode 100c.

The second light emitting diode 100b may include the second vertically stacked light emitting diode 110b and the transparent optical layer 115. Because the second light emitting diode 100b shown in FIG. 26 has a substantially same structure with the second light emitting diode 100b shown in FIG. 1, descriptions thereof will be omitted.

The third light emitting diode 100c may include a third vertically stacked light emitting diode 110c and the color conversion layer 113. The third vertically stacked light emitting diode 110c may be similar with the structure of the first vertically stacked light emitting diode 110a (referring to FIG. 2 and FIG. 3) described above, and may be different with respect to only a part of the configuration.

The third vertically stacked light emitting diode 110c may include the first light emitting part 120 which emits light of the first color and the second light emitting part 160 which is stacked at the first light emitting part 120 and emits light of the second color different from the first color. For example, the light of the first color may be a blue light, and the light of the second color may be a green light. The third vertically stacked light emitting diode 110c may be driven to individually emit light of the first color and light of the second color, respectively.

The color conversion layer 113 may include a red quantum dot (QD) which can emit light of a red wavelength band by being excited by light emitted from the third vertically stacked light emitting diode 110c.

The third vertically stacked light emitting diode 110c is different from the structure of the first vertically stacked light emitting diode 110a (referring to FIG. 2 and FIG. 3) described above in that a ninth contact electrode 191", a tenth contact electrode 193", an eleventh contact electrode 195", and a twelfth contact electrode 197" are connected in series. In this case, ninth to twelfth substrate electrodes 51", 52", 55", and 57" of a substrate 50' to which ninth to twelfth contact electrodes (ninth contact electrode 191", tenth contact electrode 193", eleventh contact electrode 195", and twelfth contact electrode 197")of the third vertically stacked light emitting diode 110c are electrically connected may be same as a pattern of the fifth to eighth substrate electrodes (fifth substrate electrode 51', sixth substrate electrode 53', seventh substrate electrode 55', and eighth substrate electrode 57') .

The third vertically stacked light emitting diode 110c will be described below with reference to the drawings, but for each configuration which is substantially same as the first vertically stacked light emitting diode 110a (referring to FIG. 4 and FIG. 5), the same reference numerals will be affixed and briefly described.

Referring to FIG. 27 and FIG. 28, the third vertically stacked light emitting diode 110c may include the first light emitting part 120, the first transparent electrode layer 130, the second light emitting part 160, the second transparent electrode layer 170, and four contact electrodes. The four contact electrodes may include the ninth contact electrode 191", the tenth contact electrode 193", the eleventh contact electrode 195", and the twelfth contact electrode 197".

The first light emitting part 120 may include the first semiconductor layer 121, the second semiconductor layer 125, and the first active layer 123 provided between the first semiconductor layer 121 and the second semiconductor layer 125. The first light emitting part 120 may not be limited to the above-described configuration, and for example, the first semiconductor layer 121 may include the n-type semiconductor layer, and the second semiconductor layer 125 may include the p-type semiconductor layer.

The first active layer 123 may be formed in the single quantum well (SQW) structure or the multi quantum well (MQW) structure. The first active layer 123 may emit light of a blue wavelength band 455 to 475 nm.

The first transparent electrode layer 130 may be provided on the second semiconductor layer 125. The first transparent electrode layer 130 may be electrically connected with the second semiconductor layer 125. The first transparent electrode layer 130 may be covered by the first passivation layer 140.

The second light emitting part 160 may be attached in a stacked state to the first light emitting part 120 by the bonding layer 150. The bonding layer 150 may be provided between the first passivation layer 140 and the third semiconductor layer 161 of the second light emitting part 160.

The second light emitting part 160 may include the third semiconductor layer 161, the fourth semiconductor layer 165, and the second active layer 163 provided between the third semiconductor layer 161 and the fourth semiconductor layer 165. The second light emitting part 160 may not be limited to the above-described configuration, and for example, the third semiconductor layer 161 may include the n-type semiconductor layer, and the fourth semiconductor layer 165 may include the p-type semiconductor layer.

The second active layer 163 may be formed in the single quantum well (SQW) structure or the multi quantum well (MQW) structure. The second active layer 163 may emit light of a green wavelength band 520 to 535 nm.

The second transparent electrode layer 170 may be provided on the fourth semiconductor layer 165. The second transparent electrode layer 170 may be electrically connected with the fourth semiconductor layer 165. The second transparent electrode layer 170 may be covered by the second passivation layer 180.

The ninth contact electrode 191", the tenth contact electrode 193", the eleventh contact electrode 195", and the twelfth contact electrode 197" may be provided at an opposite surface of a light emitting surface 121c of the third vertically stacked light emitting diode 110c. The ninth contact electrode 191", the tenth contact electrode 193", the eleventh contact electrode 195", and the twelfth contact electrode 197" may be arrayed in grid as in FIG. 28.

The ninth contact electrode 191" may be a terminal (B+/G-) in which one portion is electrically connected to the third semiconductor layer 161 of the second light emitting part 160 and another portion is electrically connected to the second semiconductor layer 125 of the first light emitting part 120 through the first transparent electrode layer 130. The tenth contact electrode 193" may be a negative pole (B-) which is electrically connected to the first semiconductor layer 121 of the first light emitting part 120. The eleventh contact electrode 195" may be a positive pole (G+) which is electrically connected to the fourth semiconductor layer 165 of the second light emitting part 160 through the second transparent electrode layer 170. The twelfth contact electrode 197" may be disposed on the second passivation layer 180 and may be a structure which is not electrically connected with the first light emitting part 120 and the second light emitting part 160.

As described above, the third vertically stacked light emitting diode 110c may be configured such that the first light emitting part 120 and the second light emitting part 160 are connected in series as the ninth contact electrode 191" connects a positive pole (B+) of the first light emitting part 120 with a negative pole (G-) of the second light emitting part 160. Accordingly, when current is applied to the eleventh contact electrode 195", the first light emitting part 120 and the second light emitting part 160 may be simultaneously driven.

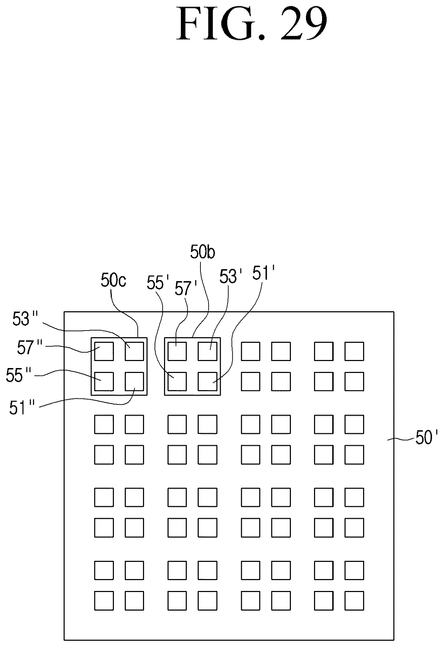

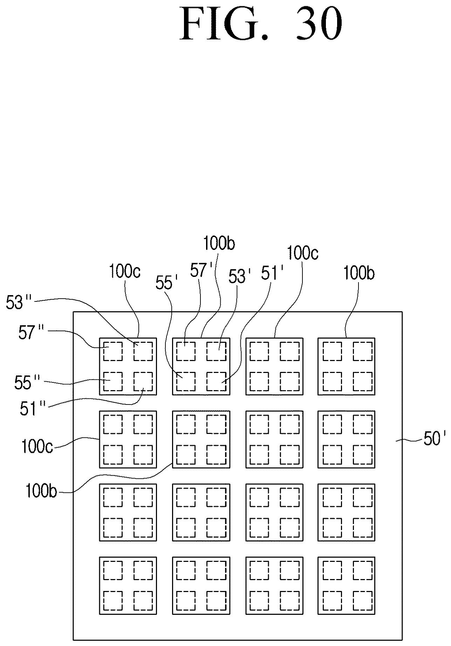

FIG. 29 is a diagram illustrating a substrate according to one or more embodiments. FIG. 30 is a diagram illustrating an example of a plurality of light emitting diodes transferred to a substrate according to one or more embodiments.

Referring to FIG. 29, the substrate 50' according to one or more embodiments may be arrayed with a plurality of substrate electrodes at a front surface thereof. The plurality of substrate electrodes may include the second substrate electrode group 50b corresponding to the second light emitting diode 100b emitting a green light and a blue light and a third substrate electrode group 50c corresponding to the third light emitting diode 100c emitting a red light.

The second substrate electrode group 50b may be configured such that the fifth substrate electrode 51', the sixth substrate electrode 53', the seventh substrate electrode 55', and the eighth substrate electrode 57' are arrayed in grid form so as to correspond to fifth to eighth contact electrodes (fifth contact electrode 191', sixth contact electrode 193', seventh contact electrode 195', and eighth contact electrode 197') of a second vertically stacked light emitting diode 110b. The fifth substrate electrode 51' of the second substrate electrode group 50b and the first light emitting part 120 connected to the sixth substrate electrode 53' may be individually driven from the second light emitting part 160 connected to the seventh substrate electrode 55' and the eighth substrate electrode 57'.

The third substrate electrode group 50c may be configured substantially same as the second substrate electrode group 50b. The third substrate electrode group 50c may be configured such that a ninth substrate electrode 51", a tenth substrate electrode 53", an eleventh substrate electrode 55", and a twelfth substrate electrode 57" are arrayed in grid form so as to correspond to the ninth to twelfth contact electrodes (ninth contact electrode 191", tenth contact electrode 193", eleventh contact electrode 195", and twelfth contact electrode 197")of a third vertical light emitting diode 110c.

Referring to FIG. 30, the third light emitting diode 100c electrically connected to the third substrate electrode group 50c (referring to FIG. 29) may be configured such that the first light emitting part 120 and the second light emitting part 160 are simultaneously driven when current is applied to the third substrate electrode group 50c. Based on the light simultaneously emitted from the first light emitting part 120 and the second light emitting part 160 being excited by the color conversion layer 113, the third light emitting diode 100c may emit a red light.

The second light emitting diode 100b electrically connected to the second substrate electrode group 50b (referring to FIG. 29) may be configured such that the first light emitting part 120 and the second light emitting part 160 are individually driven when current is applied to the second substrate electrode group 50b.

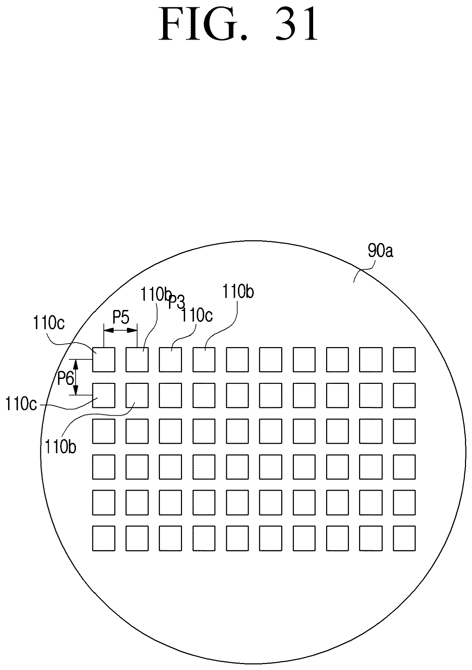

FIG. 31 is a diagram illustrating an example of a plurality of vertically stacked light emitting diodes of different types grown from a single wafer according to one or more embodiments.

Referring to FIG. 31, the second vertically stacked light emitting diode 110b and the third vertically stacked light emitting diode 110c may be formed on a single wafer 90a. The plurality of second vertically stacked light emitting diodes 110b and the plurality of third vertically stacked light emitting diodes 110c may be arrayed in grid form. In this case, the plurality of second vertically stacked light emitting diodes 110b and the plurality of third vertically stacked light emitting diodes 110c may be alternately arrayed by one column each.

The array of the plurality of second vertically stacked light emitting diodes 110b and the plurality of third vertically stacked light emitting diodes 110c on the wafer 90a may have a fifth pitch P5 in the horizontal direction, and have a sixth pitch P6 in the vertical direction. If a horizontal pitch and a vertical pitch of the plurality of second vertically stacked light emitting diodes 110b and the plurality of third vertically stacked light emitting diodes 110c to be transferred to the substrate 50 are substantially same as the fifth pitch P5 and the sixth pitch P6 on the wafer 90a, the plurality of second vertically stacked light emitting diodes 110b and the plurality of third vertically stacked light emitting diodes 110c may be directly transferred from the wafer 90a to the substrate 50 without going through a separate transfer substrate. In this case, time spent in the transfer process may be improved (such as by being reduced).

In the disclosure, the second vertically stacked light emitting diode 110b and the third vertically stacked light emitting diode 110c have been described as being formed on the single wafer 90a, but is not limited thereto. For example, the second vertically stacked light emitting diode 110b and the third vertically stacked light emitting diode 110c may be respectively formed on wafers different from one another.

A method of forming both the second vertically stacked light emitting diode 110b and the third vertically stacked light emitting diode 110c on the single wafer 90a will be described below with reference to the drawings.

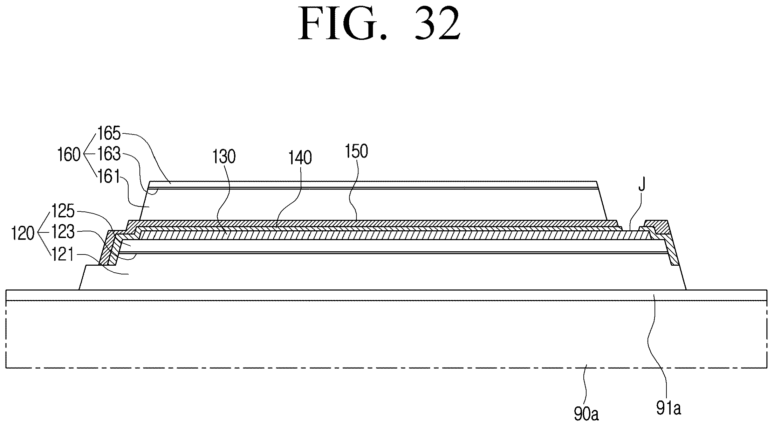

FIG. 32, FIG. 33, FIG. 34, FIG. 35, FIG. 36, and FIG. 37 are diagrams illustrating a manufacturing method of a vertically stacked light emitting diode according to one or more embodiments.

The second vertically stacked light emitting diode 110b may be formed on the wafer 90a through a substantially same process as the manufacturing method of the above-described first vertically stacked light emitting diode 110a.

A portion from among the processes for manufacturing the third vertically stacked light emitting diode 110c may be substantially same as a portion of the processes of the first vertically stacked light emitting diode 110a. For example, from the process of forming the first light emitting part 120 on a buffer layer 91a of the wafer 90a to a process of forming the second light emitting part 160 on the bonding layer 150 from among the manufacturing processes of the third vertically stacked light emitting diode 110c may be same as a portion of the processes of the first vertically stacked light emitting diode 110a (referring to FIG. 11, FIG. 12, FIG. 13, FIG. 14, FIG. 15, FIG. 16, FIG. 17, and FIG. 18). A manufacturing process of the third vertically stacked light emitting diode 110c may be described below with reference to the drawings.

Referring to FIG. 32, one portion of the bonding layer 150 and one portion of the first passivation layer 140 may be etched respectively exposing a fifth contact part J of the first transparent electrode layer 130. At the fifth contact part J, one portion of the ninth contact electrode 191" may be contacted.

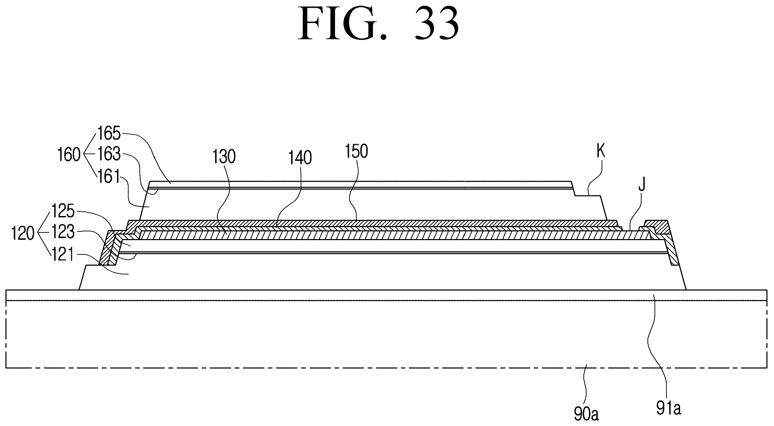

Referring to FIG. 33, one portion of the second light emitting part 160 may be etched exposing a sixth contact part K for another portion of the ninth contact electrode 191" to be in contact with the third semiconductor layer 161 of the second light emitting part 160.

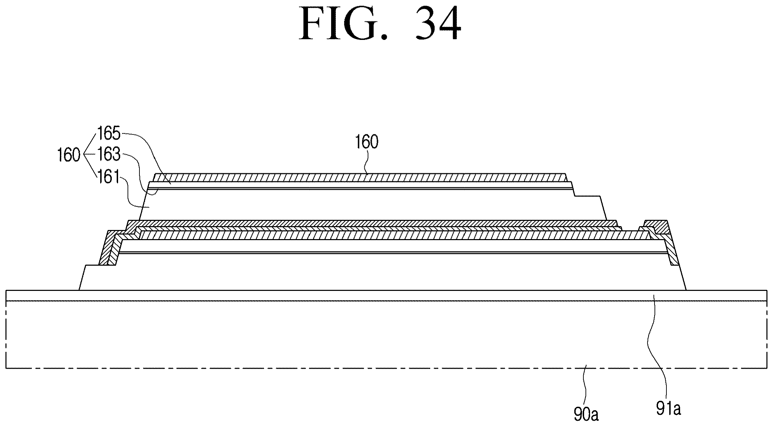

Referring to FIG. 34, the second transparent electrode layer 170 may be formed on the fourth semiconductor layer 165 of the fourth semiconductor layer 165.

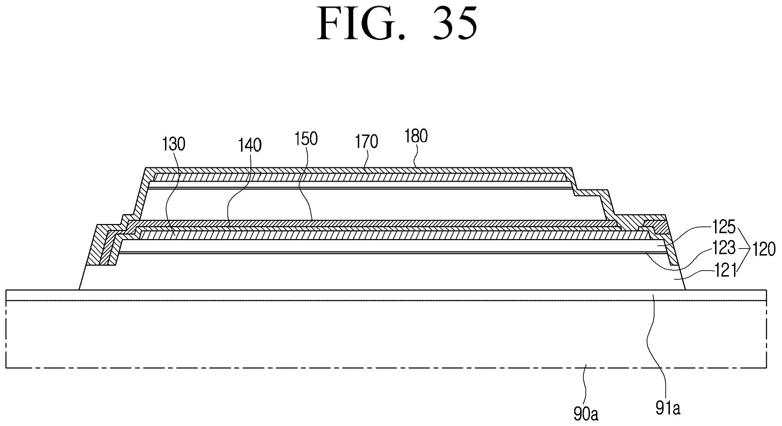

Referring to FIG. 35, the second passivation layer 180 may be formed to cover the second light emitting part 160. In this case, the second passivation layer 180 may cover both the fifth contact part J of the first transparent electrode layer 130 and the sixth contact part K of the third semiconductor layer 161.

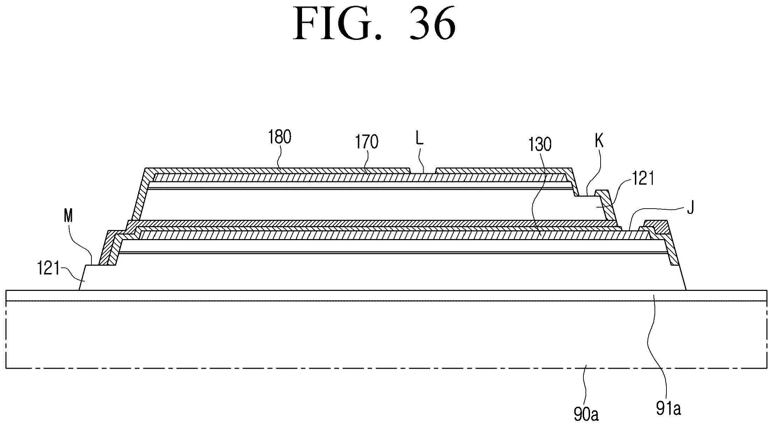

Referring to FIG. 36, the second passivation layer 180 may be etched exposing the fifth contact part J of the first transparent electrode layer 130, the sixth contact part K of the third semiconductor layer 161, a seventh contact part L of the second transparent electrode layer 170, and an eighth contact part M of the first semiconductor layer 121, respectively. At the seventh contact part L of the second transparent electrode layer 170, one end of the eleventh contact electrode 195" may be contacted. At the eighth contact part M of the first semiconductor layer 121, one end of the tenth contact electrode 193" may be contacted.

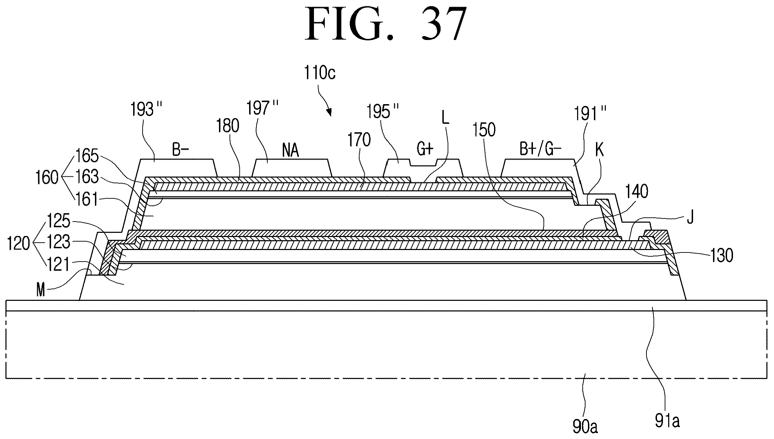

Referring to FIG. 37, the ninth contact electrode 191", the tenth contact electrode 193", the eleventh contact electrode 195", and the twelfth contact electrode 197" may be formed on the second passivation layer 180. The ninth contact electrode 191", the tenth contact electrode 193", the eleventh contact electrode 195", and the twelfth contact electrode 197" may be arrayed in a rough grid form.

The ninth contact electrode 191" may be simultaneously contacted at the fifth contact part J of the first transparent electrode layer 130 and the sixth contact part K of the third semiconductor layer 161. The tenth contact electrode 193" may be contacted at the eighth contact part M of the first semiconductor layer 121. The eleventh contact electrode 195" may be contacted at the seventh contact part L of the second transparent electrode layer 170.

The twelfth contact electrode 197" may be isolated without being electrically contacted at the first light emitting part 120 and the second light emitting part 160. The twelfth contact electrode 197" may be connected with a twelfth substrate electrode 59" of the substrate 50', but does not engage in the driving of the first light emitting part 120 and the second light emitting part 160, and may correspond to a physical connection structure with which the third vertically stacked light emitting diode 110c can be connected to the substrate 50'.

A manufacturing method of the display panel 10a according to one or more embodiments may include forming the plurality of second vertically stacked light emitting diodes 110b and the plurality of third vertically stacked light emitting diodes 110c on the single wafer 90a as described above.

The plurality of second vertically stacked light emitting diodes 110b and the plurality of third vertically stacked light emitting diodes 110c formed on the single wafer 90a may be directly transferred from the wafer 90a to the substrate 50' or transferred to a separate transfer substrate through the transfer process. When transferred to the separate transfer substrate, the plurality of second vertically stacked light emitting diodes 110b and plurality of third vertically stacked light emitting diodes 110c may be transferred from the wafer to the first transfer substrate, and after being transferred from the first transfer substrate to the second transfer substrate, may be ultimately transferred from the second transfer substrate to the substrate 50'. For example, the transfer process may involve applying the laser transfer method, the stamp transfer method, the rollable transfer method, or the pick and place transfer method.

The color conversion layer 113 may be formed at the light emitting surface 121c (referring to FIG. 26) of the plurality of third vertically stacked light emitting diodes 110c transferred to the substrate 50'.

The transparent optical layer 115 may be formed at the light emitting surface 121b (referring to FIG. 26) of the plurality of second vertically stacked light emitting diodes 110b transferred to the substrate 50.

In the disclosure, the process of forming the color conversion layer 113 has been described as preceding the process of forming the transparent optical layer 115, but is not limited thereto. For example, the process of forming the color conversion layer 113 may be performed after the process of forming the transparent optical layer 115.

As described above, when forming the display panel 10a by applying a plurality of third light emitting diodes 100c which are different in structure together with the plurality of second light emitting diodes 100b and the plurality of second light emitting diodes 100b, the substrate 50' may include a plurality of second substrate electrode groups 50b and a plurality of third substrate electrode groups 50c having a same pattern.

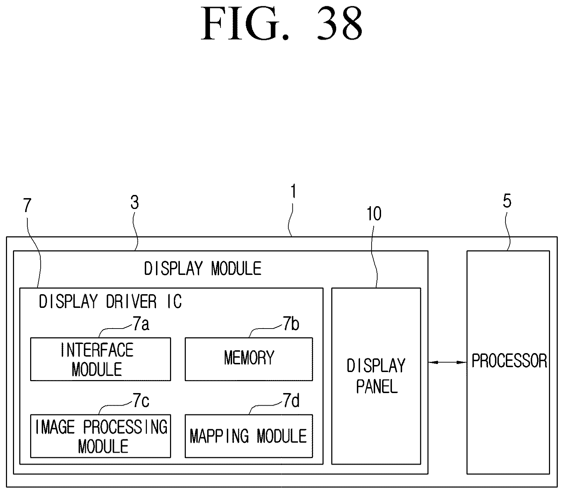

FIG. 38 is a block diagram illustrating a display device according to one or more embodiments.

Referring to FIG. 38, the display device 1 may include a display module 3 and a processor 5. The display module 3 may include the display panel 10 and a display driver integrated circuit (IC) 7 for controlling the display panel 10.

The processor 5 may be implemented as a digital signal processor (DSP) for processing a digital image signal, a microprocessor, a graphics processing unit (GPU), an artificial intelligence (AI) processor, a neural processing unit (NPU), or a time controller (TCON). However, the embodiment is not limited thereto, and may include one or more from among a central processing unit (CPU), a micro controller unit (MCU), a micro processing unit (MPU), a controller, an application processor (AP), a communication processor (CP), or an ARM processor, or may be defined by the corresponding term. In addition, the processor 5 may be implemented as a System on Chip (SoC) or a large scale integration (LSI) in which a processing algorithm is embedded, and may be implemented in the form of an application specific integrated circuit (ASIC) or a field programmable gate array (FPGA).

The processor 5 may control hardware or software elements connected to the processor 5 by driving an operating system or an application program, and perform various data processing and computations. In addition, the processor 5 may load and process commands or data received from at least one from among other elements in a volatile memory, and store various data in a non-volatile memory.

The display driver IC 7 may include an interface module 7a, a memory 7b (e.g., a buffer memory), an image processing module 7c, or a mapping module 7d. The display driver IC 7 may receive, for example, image information including an image data or an image control signal corresponding to a command for controlling the image data from other elements of the display device 1 through the interface module 7a. For example, according to an embodiment, the image information may be received from the processor 5 (e.g., a main processor (e.g., an application processor)) or an auxiliary processor (e.g., a graphics processing device) operated independently from a function of the main processor.

The display driver IC 7 may communicate through a sensor module and the interface module 7a. In addition, the display driver IC 7 may store at least a portion from among the received image information in the memory 7b, for example, on a frame basis. The image processing module 7c may perform, for example, a pre-processing or a post-processing (e.g., resolution, brightness, or size adjustment) of at least a portion of the image data based at least in part on characteristics of the image data or characteristics of the display panel 10. The mapping module 7d may generate a voltage value or a current value corresponding to the image data which is pre-processed or post-processed through the image processing module 7c. According to an embodiment, the generating of the voltage value or the current value may be performed, for example, based at least in part on characteristics of the pixels (e.g., array of pixels (an RGB stripe or a pentile structure), or sizes of the respective sub pixels) of the display panel 10. Based on at least a portion of the pixels of the display panel 10 being driven, for example, based at least in part on the voltage value of the current value, visual information (e.g., a text, an image, or an icon) corresponding to the image data may be displayed through the display panel 10.

The display driver IC 7 may transmit a driving signal (e.g., a driver driving signal, a gate driving signal, etc.) to the display based on image information received from the processor 5.

The display driver IC 7 may display an image based on an image signal received from the processor 5. In an example, the display driver IC 7 may generate a driving signal of a plurality of sub pixels based on the image signal received from the processor 5, and display an image by controlling an emission of light of the plurality of sub pixels based on the driving signal.

According to one or more embodiments, the display module 3 may further include touch circuitry. The touch circuitry may include a touch sensor and a touch sensor IC for controlling the same. The touch sensor IC may control the touch sensor to detect, for example, a touch input or a hovering input of a designated position of the display module 100. For example, the touch sensor IC may detect the touch input or the hovering input by measuring a change in signal (e.g., voltage, amount of light, resistance, or electric charge) of the designated position of the display panel 10. The touch sensor IC may provide information (e.g., position, area, pressure, or time) on the detected touch input or hovering input to the processor 5. According to an embodiment, at least a portion of the touch circuitry (e.g., the touch sensor IC) may be included in the display driver IC 7, or as a part of the display panel 10, or as a part of another element (e.g., auxiliary processor) disposed outside of the display module 3.

According to one or more embodiments, a pixel driving method of the display module 3 may be an active matrix (AM) driving method of a passive matrix (PM) driving method.

According to one or more embodiments, the display device 1 may include the display module 3. The display module 3 may display various images. Here, an image may include a still image and/or a moving image. The display module 3 may display various images such as, for example, and without limitation, broadcast content, multi-media content, and the like. In addition, the display module 3 may also display a user interface and an icon.

According to one or more embodiments, the display module 3 may be installed and applied in a wearable device, a portable device, a handheld device, and in electronic products or electric field that require various displays.

According to one or more embodiments, the display device 1 may include a plurality of display modules 3. The plurality of display modules 3 may be physically connected implementing a large-scale display (e.g., a large format display). The large-scale display may connect a plurality of display modules in the grid array and may be a monitor for a personal computer (PC), a high-resolution TV, signage (or, digital signage), or an electronic display.

The disclosure above have been shown and described with reference to various examples, but it will be understood by those skilled in the art that various changes in form and details may be made therein without departing from the true spirit and full scope of the disclosure defined by the appended claims and their equivalents.

## Claims

1. A display panel comprising:
a substrate;
a plurality of substrate electrodes on the substrate;
a plurality of first light emitting diodes electrically connected to the plurality of substrate electrodes, and configured to emit light of a first color; and
a plurality of second light emitting diodes electrically connected to the plurality of substrate electrodes, each of the plurality of second light emitting diodes being configured to emit light of a second color and emit light of a third color, wherein the second color and the third color are different from the first color.

2. The display panel of claim 1, wherein each of the plurality of first light emitting diodes comprises:
a first vertically stacked light emitting diode comprising a first light emitting part and a second light emitting part which are vertically stacked;
a color conversion layer on a light emitting surface of the first light emitting part; and
a first contact electrode, a second contact electrode, a third contact electrode, and a fourth contact electrode which are connected to the plurality of substrate electrodes.

3. The display panel of claim 2, wherein the color conversion layer comprises a quantum dot configured to emit light of the first color by exciting lights respectively emitted from the first light emitting part and the second light emitting part.

4. The display panel of claim 2, wherein the first light emitting part and the second light emitting part are connected in series via the plurality of substrate electrodes.

5. The display panel of claim 2, wherein the first light emitting part and the second light emitting part are connected in series via the first contact electrode, the second contact electrode, the third contact electrode, and the fourth contact electrode.

6. The display panel of claim 5, wherein the first contact electrode is connected to a positive pole of the first light emitting part and a negative pole of the second light emitting part,
wherein the second contact electrode is connected to a negative pole of the first light emitting part,
wherein the third contact electrode is connected to a positive pole of the second light emitting part, and
wherein the fourth contact electrode is not connected with the first light emitting part and the second light emitting part.

7. The display panel of claim 1, wherein each of the plurality of second light emitting diodes comprises:
a second vertically stacked light emitting diode comprising a third light emitting part and a fourth light emitting part which are vertically stacked;
a transparent optical layer on a light emitting surface of the third light emitting part; and
a fifth contact electrode, a sixth contact electrode, a seventh contact electrode, and an eighth contact electrode connected to the plurality of substrate electrodes.

8. The display panel of claim 7, wherein the third light emitting part is configured to emit light of the second color, and
wherein the fourth light emitting part is configured to emit light of the third color.

9. The display panel of claim 8, wherein the fifth contact electrode is connected to a negative pole of the third light emitting part,
wherein the sixth contact electrode is connected to a positive pole of the third light emitting part,
wherein the seventh contact electrode is connected to a negative pole of the fourth light emitting part, and
wherein the eighth contact electrode is connected to a positive pole of the fourth light emitting part.

10. A light emitting diode comprising:
a first light emitting part configured to emit light of a blue wavelength band;
a second light emitting part on the first light emitting part and configured to emit light of a green wavelength band;
a color conversion layer on a light emitting surface of the first light emitting part and comprising a quantum dot configured to emit light of a red wavelength band by exciting lights respectively emitted from the first light emitting part and the second light emitting part; and
a plurality of contact electrodes comprising a first contact electrode, a second contact electrode, a third contact electrode, and a fourth contact electrode.

11. The light emitting diode of claim 10, wherein the first contact electrode is connected to a negative pole of the first light emitting part,
wherein the second contact electrode is connected to a positive pole of the first light emitting part,
wherein the third contact electrode is connected to a negative pole of the second light emitting part, and
wherein the fourth contact electrode is connected to a positive pole of the second light emitting part.

12. The light emitting diode of claim 10, wherein the first contact electrode is connected to a positive pole of the first light emitting part and a negative pole of the second light emitting part,
wherein the second contact electrode is connected to a negative pole of the first light emitting part,
wherein the third contact electrode is connected to a positive pole of the second light emitting part, and
wherein the fourth contact electrode is not connected with the first light emitting part and the second light emitting part.

13. A light emitting diode comprising:
a first light emitting part configured to emit light of a blue wavelength band;
a second light emitting part on the first light emitting part and configured to emit light of a green wavelength band;
a transparent optical layer on a light emitting surface of the first light emitting part and configured to transmit light emitted from the first light emitting part and light emitted from the second light emitting part;
a first contact electrode connected to a negative pole of the first light emitting part;
a second contact electrode connected to a positive pole of the first light emitting part;
a third contact electrode connected to a negative pole of the second light emitting part; and
a fourth contact electrode connected to a positive pole of the second light emitting part.

14. A method of manufacturing a display panel, the method comprising:
forming a plurality of first vertically stacked light emitting diodes and a plurality of second vertically stacked light emitting diodes, the plurality of second vertically stacked light emitting diodes comprising a first light emitting part configured to emit light of a first color at a wafer, and a second light emitting part configured to emit light of a second color at the wafer, the first color being different from the second color;
transferring the plurality of first vertically stacked light emitting diodes and the plurality of second vertically stacked light emitting diodes from the wafer to a substrate;
forming a plurality of first light emitting diodes by forming a color conversion layer configured to emit light of the first color and light of a third color at a light emitting surface of the plurality of first vertically stacked light emitting diodes, the third color being different from the second color; and
forming a plurality of second light emitting diodes by forming a transparent optical layer at a light emitting surface of the plurality of second vertically stacked light emitting diodes.

15. The method of claim 14, wherein the first light emitting part and the second light emitting part are connected in series.
